# EUROPÄISCHE PATENTANMELDUNG

(11) **EP 3 101 807 A1**
(43) Veröffentlichungstag der Anmeldung: **07.12.2016**
(21) Anmeldenummer: 15170028.3
(22) Anmeldetag: 01.06.2015
(51) Int. Cl.: H03F 3/217, H03F 3/21, H03F 3/38

(54) **VERSTÄRKERSCHALTUNG UND VERFAHREN ZUM BETRIEB EINER VERSTÄRKERSCHALTUNG**

(71) Anmelder: Siemens Schweiz AG, 8047 Zürich (CH)
(72) Erfinder: Waldmeier, Christoph, 8854 Siebenen (CH); Kästli, Urs, 8708 Männedorf (CH)
(74) Vertreter: Maier, Daniel Oliver

(57) **Zusammenfassung**

Die Erfindung ist eine Verstärkerschaltung (10) mit einem beidseitig galvanisch isolierten und als Verstärker fungierenden Gleichspannungswandler (24), wobei ein Ausgangssignal der Verstärkerschaltung (10) mittels eines Rückführzweigs (20) auf einen eingangsseitigen Summationspunkt (22) zurückgeführt ist und der Gleichspannungswandler (24) zwischen den Summationspunkt (22) und einen ausgangsseitigen Ausgangsfilter (46) geschaltet ist, sowie ein Verfahren zum Betrieb einer solchen Verstärkerschaltung (10).

## Beschreibung

Die Erfindung betrifft eine Verstärkerschaltung sowie ein Verfahren zum Betrieb einer Verstärkerschaltung.

Verstärkerschaltungen und Verfahren zur deren Betrieb sind an sich bekannt.

Nachteilig bei bekannten Verstärkerschaltungen sind zum Beispiel ungünstige Verlustleistungen und nicht immer exakte Verstärkungsverhältnisse.

Eine Aufgabe der vorliegenden Erfindung besteht damit darin, eine Verstärkerschaltung und ein Verfahren zu deren Betrieb anzugeben, bei der im Betrieb solche ungünstigen Verlustleistungen nicht oder zumindest nur in reduziertem Umfang auftreten.

Diese Aufgabe wird erfindungsgemäß mittels einer Verstärkerschaltung mit den Merkmalen des Anspruchs 1 gelöst. Die Verstärkerschaltung umfasst einen beidseitig galvanisch isolierten und als Verstärker fungierenden Gleichspannungswandler. Ein Ausgangssignal der Verstärkerschaltung ist mittels eines Rückführzweigs auf einen eingangsseitigen Summationspunkt zurückgeführt. Diese Rückführung führt zu einer geregelten Verstärkung des jeweiligen Eingangssignals mittels des Gleichspannungswandlers. Der Gleichspannungswandler ist zwischen den Summationspunkt und einen ausgangsseitigen Ausgangsfilter geschaltet und befindet sich demnach also innerhalb des mit dem Rückführzweig geschlossenen Regelkreises.

Der Vorteil der Erfindung besteht in der aufgrund einer reduzierten Verlustleistung erhöhten Effizienz. Dies gilt speziell im Fall eines als Gleichspannungswandler fungierenden Klasse-D-Verstärkers, der bekanntlich mit einem pulsweitenmodulierten Eingangssignal arbeitet, so dass dessen Schaltelemente jeweils entweder maximal leitend oder maximal isolierend sind und dabei nur sehr wenig Verlustleistung erzeugt wird.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin. Sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bei einer Ausführungsform der Verstärkerschaltung umfasst diese einen Gleichspannungswandler, insbesondere einen Klasse-D-Verstärker, mit einer ersten Schaltstufe und einer zweiten Schaltstufe. Die beidseitige galvanische Isolation des Gleichspannungswandlers ist mittels einer eingangsseitigen und einer ausgangsseitigen galvanischen Trennung der ersten Schaltstufe von der Verstärkerschaltung realisiert. Die ausgangsseitige galvanische Trennung der ersten Schaltstufe von der Verstärkerschaltung ist dabei in Form einer galvanischen Trennung der ersten Schaltstufe und der zweiten Schaltstufe realisiert. Die erste Schaltstufe und die zweite Schaltstufe sind dabei zum Beispiel mittels zumindest eines Übertragers zur induktiven Leistungsübertragung gekoppelt, aber galvanisch getrennt. Auf der Eingangsseite kann die galvanische Trennung der ersten Schaltstufe vom Rest der Verstärkerschaltung zum Beispiel mittels eines Optokopplers oder dergleichen oder mittels eines Übertragers zur induktiven Signalübertragung realisiert sein.

Bei einer speziellen Ausführungsform der Verstärkerschaltung umfasst die erste Schaltstufe des Gleichspannungswandlers, insbesondere des Klasse-D-Verstärkers, eingangsseitig zwei gegenläufig angesteuerte Brücken und ausgangsseitig eine Übertragerwicklung sowie die zweite Schaltstufe eine beidseitig gegen Massepotential schaltbare Übertragerwicklung mit einem Mittelabgriff.

Bei einem Verfahren zum Betrieb einer solchen Verstärkerschaltung werden mittels einer Phasenkompensationsschaltung und nachfolgender Pulsweitenmodulation zwei Ansteuersignale für die erste Schaltstufe des Gleichspannungswandlers oder Klasse-D-Verstärkers erzeugt. In Abhängigkeit von den Ansteuersignalen und einer resultierenden Schaltstellung der beiden Brücken der ersten Schaltstufe ergibt sich eine alternierende Richtung einer elektrischen Spannung über der Übertragerwicklung der ersten Schaltstufe. Diese alternierende Spannung wird aus der ersten Schaltstufe ausgekoppelt. Dafür werden mittels eines Umschalters antivalente Steuersignale zur Ansteuerung von Schaltelementen der zweiten Schaltstufe generiert. Mittels dieser Schaltelemente wird jeweils eine von dem Mittelabgriff ausgehende Hälfe der mit der Übertragerwicklung der ersten Schaltstufe gekoppelten Übertragerwicklung der zweiten Schaltstufe gegen Masse geschaltet. Die Auskopplung der Spannung über der Übertragerwicklung der ersten Schaltstufe erfolgt jeweils mit der gegen Masse geschalteten Hälfte der Übertragerwicklung der zweiten Schaltstufe. Eine der Hälften der Übertragerwicklung der zweiten Schaltstufe hat eine mit der Übertragerwicklung der ersten Schaltstufe gleichsinnige Wicklungsrichtung. Die andere Hälfte hat eine mit der Übertragerwicklung der ersten Schaltstufe gegensinnige Wicklungsrichtung. Indem je nach Richtung der elektrischen Spannung über der Übertragerwicklung der ersten Schaltstufe genau eine der beiden Hälften der Übertragerwicklung der zweiten Schaltstufe zur Auskopplung der elektrischen Spannung verwendet wird, resultiert ein phasenrichtiges Zusammensetzen des Ausgangssignals, dessen zugrunde liegendes Eingangssignal zuvor mittels der beiden Ansteuersignale zerteilt wurde, um eine mittelwertfreie Verstärkung zu erhalten.

Insgesamt ist die Erfindung auch eine Vorrichtung zum Ansteuern von Alarmierungs-Einrichtungen, zum Beispiel einer als Brandmelder fungierenden Alarmierungs-Einrichtung, insbesondere Alarmierungs-Einrichtungen mit Mitteln zur Sprachausgabe, mit einer Verstärkerschaltung wie hier und im Folgenden beschrieben und/oder einer Verstärkerschaltung mit Mitteln zur Ausführung des Betriebsverfahrens.

Nachfolgend werden Ausführungsbeispiele der Erfindung anhand der Zeichnung näher erläutert. Einander entsprechende Gegenstände oder Elemente sind in allen Figuren mit den gleichen Bezugszeichen versehen.

Es zeigen
- FIG 1: eine bekannte Verstärkerschaltung inklusive einer vorgeschalteten DC-Stromversorgung,
- FIG 2: eine bekannte Verstärkerschaltung mit einem sogenannten Klasse-D-Verstärker ohne DC-Stromversorgung,
- FIG 3: eine erste beispielhafte Ausführungsform einer hier vorgeschlagenen Verstärkerschaltung und
- FIG 4: eine zweite beispielhafte Ausführungsform einer hier vorgeschlagenen Verstärkerschaltung.

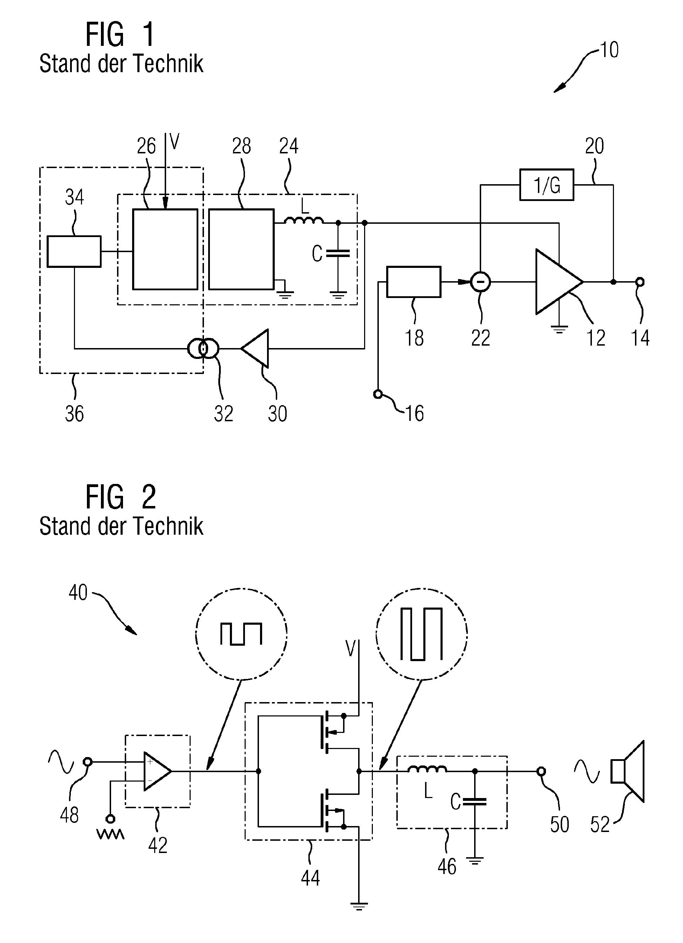

FIG 1 zeigt eine bekannte Verstärkerschaltung 10. Diese umfasst einen mit einer Versorgungsspannung gespeisten Linearverstärker 12. Am Ausgang 14 des Linearverstärkers 12 ist das verstärkte Signal abgreifbar. Auf einer Eingangsseite des Linearverstärkers 12 wird diesem das an einem Eingang 16 zugeführte Eingangssignal zugeleitet. Die Versorgungsspannung ist von einer aufgrund des Eingangssignals resultierenden Eingangsspannung galvanisch getrennt. Bei dem Eingangssignal handelt es sich beim dargestellten Beispiel um ein Digitalsignal, das mittels eines Digital-Analog-Wandlers 18 in ein mittels des Linearverstärkers 12 verarbeitbares Analogsignal umgewandelt wird. Wenn das Eingangssignal unmittelbar als Analogsignal vorliegt, ist eine eingangsseitige Digital-Analog-Wandlung selbstverständlich nicht notwendig.

Die Verstärkung mittels des Linearverstärkers 12 ist als geregelte Verstärkung ausgeführt. Dafür wird das Ausgangssignal mittels eines Rückführzweigs 20 auf den Eingang des Linearverstärkers 12 zurückgeführt. Die Rückführung erfolgt auf einen Summationspunkt 22 und mit dem inversen Verstärkungsfaktor des Linearverstärkers 12. Bei einer Verstärkung um den Faktor G wird mittels des Rückführzweigs 20 das mit 1/G beaufschlagte Ausgangssignal zurückgeführt. Die resultierende geregelte Verstärkung bewirkt, dass eine Verstärkung um einen vorgesehenen Verstärkungsfaktor auch tatsächlich erreicht wird.

Zur Versorgung des Linearverstärkers 12 mit einer konstanten Versorgungsspannung ist ein Gleichspannungswandler 24 (DC/DC-Converter) vorgesehen. Dieser umfasst eine erste und eine zweite Schaltstufe 26, 28. Die beiden Schaltstufen 26, 28 sind galvanisch voneinander getrennt, zum Beispiel im Wege einer induktiven Kopplung. Dem Gleichspannungswandler 24 wird zu dessen Versorgung in der ersten Schaltstufe 26 eine Versorgungsspannung zugeführt. Die zweite Schaltstufe 28 umfasst einen hier nicht gezeigten Ausgangsfilter (zum Beispiel einen Ausgangsfilter wie in FIG 2 gezeigt).

Zur Gewährleistung einer jeweils gewünschten DC-Ausgangsspannung wird ein Ausgangssignal des Gleichspannungswandlers 24 mittels eines Verstärkers 30 und über eine galvanische Trennung zum Beispiel in Form eines Optokopplers 32 auf den Eingang des Gleichspannungswandlers 24, nämlich einen eingangsseitigen Pulsweitenmodulator 34 zurückgeführt. Der Pulsweitenmodulator 34 erzeugt ein pulsweitenmoduliertes Eingangssignal für die erste Schaltstufe 26 des Gleichspannungswandlers 24.

Aufgrund der galvanischen Trennung der ersten und der zweiten Schaltstufe 26, 28 sowie der galvanischen Trennung der Rückführung des Ausgangssignals des Gleichspannungswandlers 24 ergibt sich ein galvanisch isolierter Bereich 36.

Anstelle einer Schaltung mit einem Linearverstärker 12 kommt ein sogenannter Klasse-D-Verstärker 40 in Betracht. Eine Grundschaltung eines solchen Klasse-D-Verstärkers 40 ist in FIG 2 gezeigt. Danach umfasst ein Klasse-D-Verstärker 40 einen Komparator 42, eine Verstärkerstufe 44 mit zwei komplementären Schaltelementen in Form von Transistoren, MOSFETs oder dergleichen, und einen Ausgangsfilter 46, hier ein als Tiefpassfilter fungierendes RC-Glied. An einen Eingang 48 des Verstärkers 40 wird als zu verstärkendes Eingangssignal ein Analogsignal angelegt, hier vereinfacht in Form eines Sinussignals gezeigt. Mittels des Komparators 42, dem an seinem einen Eingang das Eingangssignal und an seinem anderen Eingang ein Dreiecksignal zugeführt wird, wird das verstärkende Eingangssignal in ein pulsweitenmoduliertes Signal umgewandelt, wie dies auch durch die Darstellung des am Ausgang des Komparators 42 anliegenden Signals veranschaulicht ist. Das pulsweitenmodulierte Signal wird der Verstärkerstufe 44 zugeführt, welche die eigentliche Signalverstärkung bewirkt. Der Vorteil des Klasse-D Verstärkers 40 besteht dabei bekanntlich darin, dass die Schaltelemente jeweils entweder maximal leitend oder maximal isolierend sind und dabei nur sehr wenig Verlustleistung erzeugt wird. Das verstärkte pulsweitenmodulierte Signal am Ausgang der Verstärkerstufe 44 ist in der Darstellung in FIG 2 symbolisch gezeigt und dieses wird mittels eines die Schaltung abschließenden Ausgangsfilters 46 wieder in ein Analogsignal umgewandelt. An einem Ausgang 50 des Verstärkers 40 ist demgemäß das in der Darstellung zur Veranschaulichung auch als Sinussignal mit erhöhter (verstärkter) Amplitude gezeigte verstärkte Ausgangssignal abgreifbar und dieses kann zum Beispiel einem Lautsprecher 52 oder dergleichen zugeführt werden.

Ein Klasse-D-Verstärker 40 kann bekanntlich als Gleichspannungswandler 24 (FIG 1) verwendet werden. Insofern besteht eine konkrete Ausführungsform des in FIG 1 gezeigten Gleichspannungswandlers 24 zum Beispiel darin, dass als erste Schaltstufe 26 eine Verstärkerstufe 44 eines Klasse-D-Verstärkers 40 und dass als zweite Schaltstufe 28 ein Ausgangsfilter 46 eines Klasse-D-Verstärkers 40 fungieren.

Der Nachteil der Schaltung in FIG 1 besteht darin, dass die verfügbare Leistung durch die Verluste des Linearverstärkers 12 begrenzt ist. Speziell bei einem ausgangsseitigen Kurzschluss ergeben sich hohe Verluste und der resultierende Kurzschlussstrom ist schwer zu handhaben. Bei einer Verwendung eines Klasse-D-Verstärkers 40 als Gleichspannungswandler 24 ist dessen Betrag zu den Gesamtverlusten entsprechend der Charakteristika eines Klasse-D-Verstärkers 40 vergleichsweise gering. Bei einer anderen Ausführung des Gleichspannungswandlers 24 kommen dessen Verluste noch zu den Verlusten des Linearverstärkers 12 hinzu.

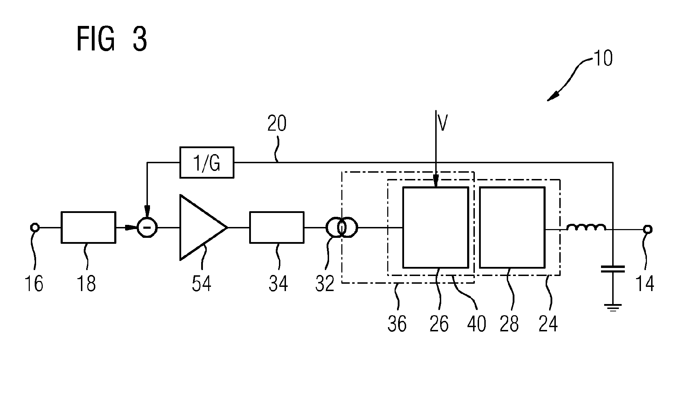

Zur Vermeidung solcher ungünstiger Verluste und der damit einhergehenden Leistungsbegrenzung wird entsprechend eine verbesserte Verstärkerschaltung 10 vorgeschlagen und in FIG 3 ist eine Ausführungsform einer solchen Verstärkerschaltung 10 gezeigt.

Die Verstärkerschaltung 10 weist selbstverständlich einen Eingang 16 und einen Ausgang 14 auf. Am Eingang 16 ist der Verstärkerschaltung 10 das jeweils zu verstärkende Eingangssignal zuführbar und wird dieser beim Betrieb derselben zugeführt. Am Ausgang 14 ist das verstärkte Signal abgreifbar und wird beim Betrieb der Verstärkerschaltung 10 dort abgegriffen. Bei dem Eingangssignal handelt es sich um ein Digitalsignal, das mittels eines Digital-Analog-Wandlers 18 auf einer Eingangsseite der Verstärkerschaltung 10 zunächst in ein Analogsignal umgewandelt wird. Im Anschluss an den Digital-Analog-Wandler 18 befindet sich eine Summationsstelle. Hier wird das mittels des Rückführzweigs 20 zurückgeführte und mit der inversen Gesamtverstärkung der Verstärkerschaltung 10 beaufschlagte Ausgangssignal eingekoppelt. Die Rückführung des Ausgangssignals führt insgesamt zu einer mit der Verstärkerschaltung 10 erreichten geregelten Verstärkung. Bei der Einkopplung wird das zurückgeführte Ausgangssignal vom Eingangssignal subtrahiert, so dass das resultierende Signal nach der Summationsstelle einem bei der Verstärkung verbliebenen Fehler entspricht. Das zurückgeführte Ausgangssignal ist in üblicher Art und Weise aufgrund der Rückführung mit einer Phasenverschiebung von 180° behaftet. Eine zusätzliche Phasenverschiebung von 180° resultiert aufgrund der LC-Kombination des Ausgangsfilters 46. Zur Gewährleistung der Stabilität der Verstärkerschaltung 10 wird die sich in Summe ergebende Phasenverschiebung mittels eines Phasenschiebers 54 korrigiert. Anschließend erfolgt mittels eines Pulsweitenmodulators 34 eine Pulsweitenmodulation und das resultierende, pulsweitenmodulierte Signal wird über eine galvanische Trennung, zum Beispiel in Form eines Optokopplers 32, auf den Eingang des Gleichspannungswandlers 24 gegeben. Bei diesem handelt es sich um einen als Klasse-D-Verstärker 40 (FIG 2) fungierenden Gleichspannungswandler 24 (DC/DC-Konverter), so dass dessen erste Schaltstufe 26 der Verstärkerstufe 44 des Klasse-D-Verstärkers 40 und dessen zweite Schaltstufe 28 dem Ausgangsfilter 46 des Klasse-D-Verstärkers 40.

Ein Vorteil der Verstärkerschaltung 10 gemäß FIG 3 besteht darin, dass durch die Verstärkung mittels des Klasse-D-Verstärkers 40 nur sehr wenig Verlustleistung erzeugt wird. Die bisher mit der innerhalb der Verstärkerschaltung 10 (FIG 1) anfallenden Verlustleistung einhergehende Leistungsbeschränkung wird damit vermieden und die Gesamteffizienz der Verstärkerschaltung 10 entspricht der Effizienz des Klasse-D-Verstärkers 40. Speziell bei einer mittels einer Batterie oder dergleichen bereitgestellten Versorgungsspannung V fällt besonders positiv ins Gewicht, dass die Verluste im niedrigen Leistungsbereich deutlich reduziert sind. Die Lebensdauer einer solchen Spannungsquelle, insbesondere einer Batterie, wird auf diese Weise deutlich erhöht. Ein weiterer Vorteil ist die Reduktion des Gesamtschaltungsaufwandes. Diese Reduktion ist aufgrund einer "Mehrfachverwendung" einzelner Schaltungsteile möglich, nämlich des Pulsweitenmodulators 34, der ersten und zweiten Schaltstufe 26, 28 und des Ausgangsfilters 46 des DC/DC-Konverters. Diese Schaltungsteile werden gleichzeitig zur Erzeugung der Versorgungsspannung wie zur Verstärkung des Eingangssignals genutzt.

Der Klasse-D-Verstärker 40 wird mit der jeweiligen eingangsseitigen Versorgungsspannung V versorgt. Die galvanische Trennung der Verstärkerschaltung 10 von der Versorgungsspannung V wird erreicht, indem die erste Schaltstufe 26 des Klasse-D-Verstärkers 40 eingangsseitig und ausgangsseitig vom Rest der Verstärkerschaltung 10 galvanisch getrennt ist. Eingangsseitig kann dies mittels eines Optokopplers 32 oder auch mittels einer induktiven Kopplung erfolgen. Ausgangsseitig ist die galvanische Trennung in Form einer induktiven Kopplung der ersten Schaltstufe 26 an die zweite Schaltstufe 28 realisiert.

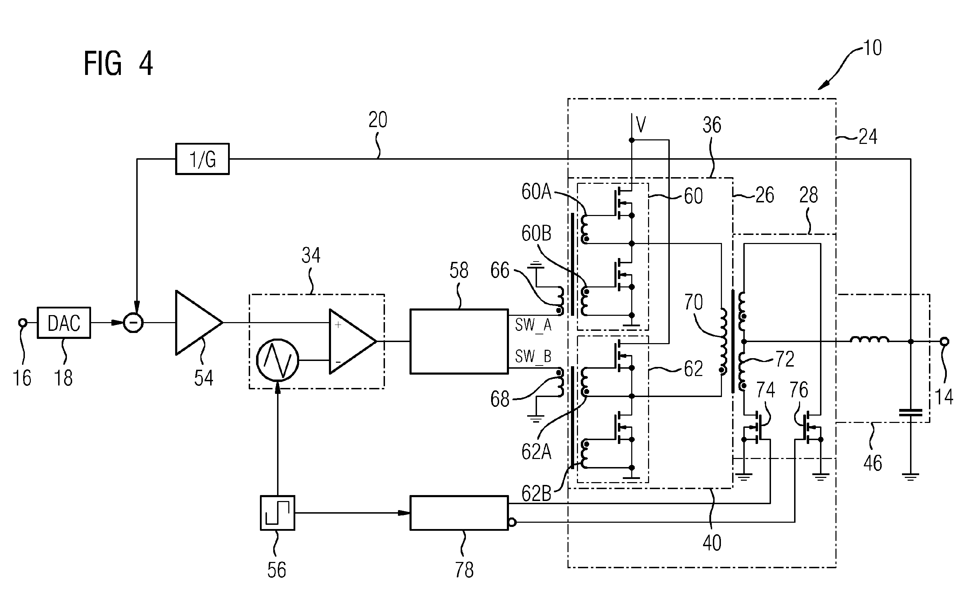

Die Darstellung in FIG 4 zeigt eine spezielle Ausführungsform der Verstärkerschaltung 10 gemäß FIG 3. Die Besonderheit besteht in einer speziellen Ausführungsform des Klasse-D-Verstärkers 40. Die eingangsseitige Digital-Analogwandlung und der Rückführzweig 20 zum Erhalt einer geregelten Verstärkung sind identisch zu der Verstärkerschaltung 10 gemäß FIG 3. Auch der Phasenschieber 54 und der Pulsweitenmodulator 34 sind identisch. Der Pulsweitenmodulator 34 ist hier mit weiteren Details gezeigt. Bekanntlich lässt sich eine pulsweitenmodulierte Form eines Eingangssignals mittels eines Komparators 42, dem an seinem einen Eingang das Eingangssignal und an seinem anderen Eingang ein Dreiecksignal zugeführt wird, erreichen (siehe auch FIG 2). Dies ist in der Darstellung in FIG 4 gezeigt. Das dem Komparator 42 zugeführte Dreiecksignal entsteht aufgrund eines Rechtecksignals von einem im Folgenden als Taktgenerator 56 bezeichneten Frequenzgenerator.

Die erste Schaltstufe des Klasse-D-Verstärkers 40 ist in Form einer Brückenschaltung mit zwei gegenläufig angesteuerten Brücken 60, 62 ausgeführt. Jede Brücke 60, 62 umfasst zwei Induktivitäten 60A, 60B; 62A, 62B mit jeweils gegenläufigem Wicklungssinn. Die Induktivitäten 60A, 60B; 62A, 62B dienen zur eingangsseitigen galvanischen Entkopplung der ersten Schaltstufe 26. Dafür werden mittels einer Phasenkompensationsschaltung 58 aus dem Ausgangssignal des Pulsweitenmodulators 34 zwei Ansteuersignale (SW_A, SW_B) zur Ansteuerung der ersten Schaltstufe 26 generiert und auf jeweils eine jeweils einer Brücke 60, 62 der ersten Schaltstufe 26 zugeordnete Induktivität 60A oder 60B bzw. 62A oder 62B geführt. Bei den Ansteuersignalen (SW_A, SW_B) handelt es sich um pulsweitenmodulierte Signale. Die Brücke 60, 62 der ersten Schaltstufe 26 ist demnach mittels pulsweitenmodulierter Signale sowie mittels phasenverschobener und aus pulsweitenmodulierten Signalen generierter Signale ansteuerbar.

Die beiden Brücken 60, 62 in der ersten Schaltstufe 26 führen zu einer mittelwertfreien Energieübertragung innerhalb des Klasse-D-Verstärkers 40. Eine solche mittelwertfreie Energieübertragung ist nötig, um die Energie mittels eines Hochfrequenz-Transformators mit einer Schaltfrequenz von zum Beispiel dem zehnfachen bis zwanzigfachen der höchsten Frequenz des Eingangssignals zu übertragen. Für eine halbe Periodendauer eines pulsweitenmodulierten Signals wird zum Beispiel das auf die erste Induktivität 66 geführte Ansteuersignal (SW_A) und für den Rest der Periodendauer das auf die zweite Induktivität 68 geführte Ansteuersignal (SW_B) generiert. Über die ausgangsseitige galvanische Entkopplung mittels einer der ersten Schaltstufe 26 zugeordneten Übertragerwicklung 70 sowie einer damit gekoppelten und der zweiten Schaltstufe 28 zugeordneten Übertragerwicklung 72 mit Mittelabgriff erfolgt die galvanisch entkoppelte Energieübertragung zur zweiten Schaltstufe 28 und zum dortigen Ausgangsfilter 46 sowie zum Ausgang 14. Die Energieübertragung zur zweiten Schaltstufe 28 ist eine synchrone Gleichrichtung, diese setzt gewissermaßen das zerhackte Signal wieder zusammen.

Die beiden Brücken 60, 62 der ersten Schaltstufe 26 verbinden die beiden Anschlusskontakte der Übertragerwicklung 70 alternierend entweder mit der Versorgungsspannung V oder mit Massepotential. Die beiden Anschlusskontakte werden zur Unterscheidung entsprechend der Darstellung als oberer und unterer Anschlusskontakt bezeichnet. Die Brücke 60 verbindet den oberen Anschlusskontakt der Übertragerwicklung 70 je nach Status des Ansteuersignals SW_A entweder mit der Versorgungsspannung V oder Massepotential und die Brücke 62 verbindet den unteren Anschlusskontakt je nach Status von deren Ansteuersignal SW_B entweder mit Massepotential oder der Versorgungsspannung V. Eine verschwindende Spannung über der Übertragerwicklung 70 kann zum Beispiel erzeugt werden, indem beide Brücken 60, 62 - aufgrund einer Ansteuerung mittels entsprechender Ansteuersignale (SW_A, SW_B) - die Übertragerwicklung 70 beidseitig mit der Versorgungsspannung V oder Massepotential verbinden.

Die induktive Kopplung der Induktivität 66 mit einer der Induktivitäten 60A, 60B bzw. - je nach Ansteuersignal (SW_A, SW_B) - die induktive Kopplung der Induktivität 68 mit einer der Induktivitäten 62A, 62B bildet einen Übertrager auf einer Eingangsseite der ersten Schaltstufe 26. Die induktive Kopplung der Übertragerwicklung 70 und einer der vom Mittelabgriff ausgehenden Hälften der Übertragerwicklung 72 bildet einen Übertrager auf einer Ausgangsseite der ersten Schaltstufe 26. Die Verstärkung resultiert aufgrund der Erzeugung eines pulsweitenmodulierten Signals mit der Amplitude der anliegenden Versorgungsspannung V. Schwankungen der Versorgungsspannung V werden mit der über den Rückführzweig 20 geschlossenen Regelschleife ausgeglichen. Bei einem aufgrund des Eingangssignals resultierenden pulsweitenmodulierten Signal auf der Eingangsseite der ersten Schaltstufe 26 mit einer Amplitude von z.B. 3V und einer Versorgungsspannung V von 30V ergibt sich eine Verstärkung um den Faktor zehn.

Die alternierende Einkopplung des zu verstärkenden Signals in die erste Schaltstufe 26 wird mittels einer alternierenden Auskopplung (synchrone Gleichrichtung) wieder aufgelöst. Dies erfolgt mittels der zweiten Schaltstufe 28. Die dortige Übertragerwicklung 72 mit dem Mittelabgriff ist beidseitig jeweils an ein Schaltelement 74, 76 angeschlossen. Bei einer Aktivierung des jeweiligen Schaltelements 74, 76 ist die Übertragerwicklung 72 auf der betreffenden Seite mit Massepotential verbunden. Je nach Aktivierung eines der beiden Schaltelemente 74, 76 ist mit der Übertragerwicklung 70 der ersten Schaltstufe 26 ein Abschnitt der Übertragerwicklung 72 mit gleichsinnigen oder gegensinnigem Wicklungssinn gekoppelt. Die Ansteuerung der beiden Schaltelemente 74, 76 erfolgt mittels eines von dem Taktgenerator 56 angesteuerten Umschalters 78. Der Umschalter 78 hat zwei Ausgänge, wobei einer der Ausgänge ein invertierender Ausgang ist. Aufgrund der resultierenden antivalenten Ausgangssignale des Umschalters 78 ist demgemäß immer genau eines der beiden Schaltelemente 74, 76 aktiviert (durchgeschaltet, leitend) und das andere deaktiviert (offen).

Die Steuersignale (SW_A, SW_B) ergeben sich aufgrund des phasenmodulierten Eingangssignals der ersten Schaltstufe 26. Dieses ist wiederum von dem Taktsignal des Taktgenerators (Taktgebers) 56 abhängig. Von dem Taktsignal des Taktgenerators 56 sind aber auch die mittels des Umschalters 78 generierten Steuersignale für die Schaltelemente 74, 76 abhängig. Die galvanisch isolierte Einkopplung in die erste Schaltstufe 26 und die Auskopplung aus der ersten Schaltstufe 26 erfolgen demnach auf derselben Zeitbasis, nämlich auf Grundlage des von dem Taktgenerator 56 generierten Taktsignals. Dies gewährleistet die phasenrichtige Auskopplung des verstärkten Signals. Am Ausgang der Verstärkerschaltung 10 erfolgen mittels eines Ausgangsfilters 46 wieder eine Glättung des pulsweitenmodulierten Ausgangssignals und damit eine Erzeugung eines Analogsignals.

Obwohl die Erfindung im Detail durch das Ausführungsbeispiel näher illustriert und beschrieben wurde, so ist die Erfindung nicht durch das oder die offenbarten Beispiele eingeschränkt und andere Variationen können vom Fachmann hieraus abgeleitet werden, ohne den Schutzumfang der Erfindung zu verlassen.

Einzelne im Vordergrund stehende Aspekte der hier eingereichten Beschreibung lassen sich damit kurz wie folgt zusammenfassen: Angegeben werden eine Verstärkerschaltung 10 und ein Verfahren zu deren Betrieb, wobei die Verstärkerschaltung 10 einen beidseitig galvanisch isolierten und als Verstärker fungierenden Gleichspannungswandler 24 umfasst, wobei ein Ausgangssignal der Verstärkerschaltung 10 mittels eines Rückführzweigs 20 auf einen eingangsseitigen Summationspunkt 22 zurückgeführt ist und der Gleichspannungswandler 24 zwischen den Summationspunkt 22 und einen ausgangsseitigen Ausgangsfilter 46 geschaltet ist. Die bei einem getrennten Aufbau des Spannungsversorgungsteils und des Verstärkungsteils redundanten Schaltungsteile, nämlich der Pulsweitenmodulator 34, die erste und die zweite Schaltstufe 26, 28 und der Ausgangsfilter 46 des DC/DC-Konverters, werden gleichzeitig zur Erzeugung der Versorgungsspannung wie zur Verstärkung des Eingangssignals genutzt.

### Bezugszeichenliste

- 10: Verstärkerschaltung
- 12: Linearverstärker
- 14: Ausgang
- 16: Eingang
- 18: Digital-Analog-Wandler
- 20: Rückführzweig
- 22: Summationspunkt
- 24: Gleichspannungswandler
- 26, 28: erste bzw. zweite Schaltstufe
- 30: Verstärker
- 32: Optokoppler
- 34: Pulsweitenmodulator
- 36: galvanisch isolierter Bereich
- 38: (frei)
- 40: Klasse-D-Verstärker
- 42: Komparator
- 44: Verstärkerstufe
- 46: Ausgangsfilter
- 48: Eingang
- 50: Ausgang
- 52: Lautsprecher
- 54: Phasenschieber
- 56: Taktgenerator
- 58: Phasenkompensationsschaltung
- 60, 62: Brücke (einer Brückenschaltung der ersten bzw. zweiten Schaltstufe)
- 60A, 60B: Induktivität
- 62A, 62B: Induktivität
- 64: (frei)
- 66, 68: Induktivität
- 70, 72: Übertragerwicklung
- 74, 76: Schaltelement
- 78: Umschalter

## Patentansprüche

1. Verstärkerschaltung (10) mit einem beidseitig galvanisch isolierten und als Verstärker fungierenden Gleichspannungswandler (24),
wobei ein Ausgangssignal der Verstärkerschaltung (10) mittels eines Rückführzweigs (20) auf einen eingangsseitigen Summationspunkt (22) zurückgeführt ist und der Gleichspannungswandler (24) zwischen den Summationspunkt (22) und einen ausgangsseitigen Ausgangsfilter (46) geschaltet ist.

2. Verstärkerschaltung (10) nach Anspruch 1 mit einem als Klasse-D-Verstärker (40) fungierenden Gleichspannungswandler (24).

3. Verstärkerschaltung (10) nach Anspruch 1 oder 2,
wobei der Gleichspannungswandler (24) eine erste Schaltstufe (26) und eine zweite Schaltstufe (28) umfasst,
wobei die beidseitige galvanische Isolation des Gleichspannungswandlers (24) mittels einer eingangsseitigen galvanischen Trennung der ersten Schaltstufe (26) von der Verstärkerschaltung (10) und einer ausgangsseitigen galvanischen Trennung der ersten Schaltstufe (26) von der Verstärkerschaltung (10) realisiert ist und
wobei die ausgangsseitige galvanische Trennung der ersten Schaltstufe (26) von der Verstärkerschaltung (10) in Form einer galvanischen Trennung der ersten Schaltstufe (26) und der zweiten Schaltstufe (28) realisiert ist.

4. Verstärkerschaltung (10) nach einem der Ansprüche 1 bis 3,
wobei der Gleichspannungswandler (24) eine erste Schaltstufe (26) mit eingangsseitig zwei gegenläufig angesteuerten Brücken (60, 62) und ausgangsseitig einer Übertragerwicklung (70) sowie eine zweite Schaltstufe (28) mit einer beidseitig gegen Massepotential schaltbaren Übertragerwicklung (72) mit einem Mittelabgriff aufweist.

5. Verfahren zum Betrieb einer Verstärkerschaltung (10) nach einem der vorangehenden Ansprüche,
wobei ein zu verstärkendes Eingangssignal in ein pulsweitenmoduliertes Signal umgewandelt und galvanisch isoliert zur Verstärkung dem mit einer Versorgungsspannung gespeisten Gleichspannungswandler (24) zugeführt wird,
wobei das verstärkte Signal auf einer Ausgangsseite des Gleichspannungswandlers (24) galvanisch isoliert einem Ausgangsfilter (46) der Verstärkerschaltung (10) zugeführt wird und
wobei das resultierende Ausgangssignal mittels des Rückführzweigs (20) auf den eingangsseitigen Summationspunkt (22) zurückgeführt wird.

6. Verfahren nach Anspruch 5 zum Betrieb einer Verstärkerschaltung (10) nach Anspruch 4,
wobei aus einem pulsweitenmodulierten Eingangssignal mittels einer Phasenkompensationsschaltung (58) zwei Ansteuersignale (SW_A, SW_B) erzeugt werden,
wobei jeweils eine Brücke (60, 62) mit jeweils einem Ansteuersignal (SW_A, SW_B) angesteuert wird,
wobei eine Brücke (60, 62) direkt mit einem pulsweitenmodulierten Signal oder mit einem aus einem pulsweitenmodulierten Signal generierten phasenverschobenen Eingangssignal angesteuert wird,
wobei sich in Abhängigkeit von den Ansteuersignalen (SW_A, SW_B) und einer resultierenden Schaltstellung der beiden Brücken (60, 62) eine alternierende Richtung einer elektrischen Spannung über der Übertragerwicklung (70) ergibt,
wobei mittels eines Umschalters (78) antivalente Steuersignale zur Ansteuerung von Schaltelementen (74, 76) generiert werden, mittels derer eine von dem Mittelabgriff ausgehende Hälfte der mit der Übertragerwicklung (70) gekoppelten Übertragerwicklung (72) gegen Masse geschaltet wird,
wobei mittels der antivalenten Ansteuerung der Schaltelemente (74, 76) jeweils genau eine von dem Mittelabgriff ausgehende Hälfte der Übertragerwicklung (70) mit der Übertragerwicklung (72) gekoppelt ist und
wobei mittels der resultierenden Kopplung der Übertragerwicklungen (70, 72) eine phasenrichtige Auskopplung der Spannung über der Übertragerwicklung (70) erfolgt.

7. Vorrichtung zur Ansteuerung eines Alarmierungs-Einrichtung, insbesondere einer Alarmierungs-Einrichtung mit Mitteln zur Sprachausgabe, mit einer Verstärkerschaltung (10) nach einem der Ansprüche 1 bis 4 oder einer Verstärkerschaltung (10) mit Mitteln zur Ausführung des Verfahrens nach Anspruch 5.

8. Alarmierungs-Einrichtung, insbesondere Alarmierungs-Einrichtung mit Mitteln zur Sprachausgabe, mit einer Verstärkerschaltung (10) nach einem der Ansprüche 1 bis 4 oder einer Verstärkerschaltung (10) mit Mitteln zur Ausführung des Verfahrens nach Anspruch 5 oder mit einer Vorrichtung nach Anspruch 7.
